Europäisches Patentamt

European Patent Office

Office européen des brevets

(11) Publication number: **0 092 367**
**B1**

## EUROPEAN PATENT SPECIFICATION

(45) Date of publication of patent specification: **19.07.89**

(21) Application number: **83302058.9**

(22) Date of filing: **13.04.83**

(51) Int. Cl.⁴: **G 01 J 9/02**, G 01 H 9/00, G 01 D 5/26

(54) Sensor using fiber interferometer.

(30) Priority: **14.04.82 US 368422**

(43) Date of publication of application:
**26.10.83 Bulletin 83/43**

(45) Publication of the grant of the patent:
**19.07.89 Bulletin 89/29**

(84) Designated Contracting States:
**AT BE CH DE FR GB IT LI LU NL SE**

(56) References cited:
DE-A-3 039 235
US-A-4 162 397

PHYSICS OF FIBER OPTICS, vol. 2, 1981, pages 493-514, Ed. A. Cer. Soc., Columbus, Ohio, USA. J.A. BUCARO et al.: "Optical fiber sensor development"

IEEE TRANSACTIONS ON MICROWAVE THEORY AND TECHNIQUES, vol. MTT-30, no. 4, April 1982, pages 472-511, New York, USA. T.G. GIALLORENZI et al.: "Optical fiber sensor technology"

(73) Proprietor: **THE BOARD OF TRUSTEES OF THE LELAND STANFORD JUNIOR UNIVERSITY**
**Encina 105 Stanford University**
**Stanford California 94305 (US)**

(72) Inventor: **Shaw, Herbert John**
**719 Alvarado Row**
**Stanford California 94305 (US)**

(74) Representative: **Rushton, Ronald et al**
**SOMMERVILLE & RUSHTON 11 Holywell Hill**
**St. Albans Hertfordshire AL1 1EZ (GB)**

(56) References cited:
APPLIED OPTICS, vol. 20, no. 2, 15th January 1981, pages 286-289, New York, USA. D.M. SHUPE: "Fiber resonator gyroscope: sensitivity and thermal nonreciprocity"

OPTICS LETTERS, vol. 6, no. 10, October 1981, pages 502-504, New York, USA. R.A. BERGH et al.: "All-single-mode fiber-optic gyroscope with long-term stability"

OPTICS LETTERS, vol. 4, no. 5, May 1979, pages 152-154. R. ULRICH et al.: "Fiber-ring interferometer: polarization analysis"

Courier Press, Leamington Spa, England.

## Description

This invention relates generally to closed loop or "Sagnac" fiber optic interferometers, and, more particularly, the invention relates to sensors for environmental quantities which can affect fiber optic waveguides in fiber optic interferometers.

Interferometers work on the principle of phase change between two coherent signals which are interfered together. Closed loop interferometers measure the relative phase change on a "global" scale, i.e., they measure the overall relative phase change between two counterpropagating light signals in a single loop of fiber.

The optical fiber loops of interferometers are sensitive to a large number of environmental effects such as temperature, acoustic pressure, vibration, motion, and electric and magnetic fields. These external phenomena can change the optical transmission characteristics of the fiber such as by changing the birefringence in the fiber or the geometric path length or the velocity of propagation of light signals through the fiber, which can result in changes in the amplitude, phase, or polarization of light propagating therethrough. This sensitivity to environmental effects means that fiber interferometer loops may function as sensor elements so long as the desired quantity to be sensed can be isolated from the other environmental quantities to which the fiber is sensitive.

A distinction should be made in the reader's mind between environmental effects which are "reciprocal" (i.e., effects which do not cause a phase shift between the counterpropagating waves) and environmental effects which are "non-reciprocal" (i.e., those effects which do cause a phase shift between counterpropagating waves). Additionally, reciprocal and non-reciprocal effects may be thought of either as being on a "global scale", wherein the effect of the environmental phenomena is considered with respect to the loop as a whole, or as being on a "differential scale", wherein the phenomena is considered only with respect to a localized, tiny segment of the fiber. Certain environmental effects such as rotation and the Faraday effect cause non-reciprocal effects on the differential scale in that they will cause a relative phase change between counterpropagating light signals travelling through the same tiny piece of fiber. These non-reciprocal differential effects are cumulative so that the resulting effect on a global scale is also non-reciprocal. Other environmental effects, such as pressure, are reciprocal on the differential scale in that they cause no net relative phase change between counterpropagating light signals travelling through the same tiny piece of fiber. On a global scale, the cumulative effect of these reciprocal differential effects is ordinarily also reciprocal. Such reciprocal effects on the differential scale, therefore, cannot be measured by a closed loop interferometer unless some way is devised to make these effects non-reciprocal on the global scale even though they are reciprocal on the differential scale.

In the prior art, the closed loop interferometer is typically used to sense non-reciprocal differential effects, such as rotation. When operated with a polarizer which limits the optical paths of the counterpropagating light to a single one of the polarization modes, as disclosed in copending U.S. Patent Application Serial No. 319,311, filed November 9, 1981 (EP—A—75013) which is a continuation in part of U.S. Patent Application serial number 307,095 filed on September 30, 1981 which is a continuation in part of U.S. Patent Application serial number 249,714 filed on March 31, 1981 (US—A—4 410 275), the closed loop interferometer is basically stable and, on a global scale, is relatively insensitive to environmental effects other than non-reciprocal, differential effects, such as motion. In such interferometers, any reciprocal, differential environmental phenomena, such as temperature or pressure, affects the fiber optical light transmission characteristics of both counterpropagating light signals substantially equally and, therefore, results in little or no relative phase change between the counterpropagating signals. The present invention teaches a closed loop interferometer configuration which senses differential reciprocal effects, such as acoustic pressure, by making their effect on the global scale non-reciprocal.

The present invention is directed to use of the closed loop optical interferometer to sense environmental phenomena which normally produce reciprocal effects on an infinitesimal length of fiber by causing them to produce non-reciprocal effects. Briefly, this is accomplished by making the sensed phenomenon spatially asymmetrical and non-uniform with respect to the closed loop. The fundamental principle which is utilized in the three basic embodiments disclosed herein is to cause the quantity Q to be sensed to be applied to the closed loop of the interferometer such that Q is time varying and is applied at a point that is offset from the center of the path around the loop, i.e., a rapidly time varying Q is applied at a point on the path such that one of the counterpropagating light signals has farther to travel to the detector than the other. As used herein, the term "counterpropagating waves" or the term "counterpropagating light signals" means collectively both of the light signals travelling in opposite directions in the loop of the interferometer. The term "counterpropagating wave" (or light signal) means only the light wave travelling in the loop in the direction opposite the direction of travel for the acoustic wave.

A special case of the fundamental principle of making the quantity to be sensed spatially asymmetrical and non-uniform with respect to its effect on the two counterpropagating light signals is disclosed in the first two embodiments disclosed because it is easier to grasp the basic principle by these two examples. These two embodiments are sensors for acoustic waves which utilize coils of fiber optic waveguide that

are specially wound so that the effect of the acoustic wave is non-uniform on the two counterpropagating light waves. That is, the loop is wound and arranged with respect to the wave to be sensed such that the subject wave has a uniform effect on the copropagating light signal, i.e., the light signal travelling in the same direction as the subject wave, but has a non-uniform effect on the counterpropagating light signal. This is done in the first embodiment by winding the coil such that the axial velocity of the co-propagating light wave along the longitudinal axis of the coil matches the velocity of propagation of the acoustic wave along the longitudinal axis. In the second embodiment, the fundamental principle is utilized by winding two coils separated in space by 1/4 of the wavelength of the acoustic wave with the size of the coil diameter and the number of turns selected such that the transit time for the light signals through each coil is 1/4 of the period of the acoustic wave. The length of each coil is also selected such that the coil occupies a very small space compared to the wavelength of the acoustic wave such that the coil is affected substantially uniformly by the portion of the acoustic wave by which it is enveloped.

In the preferred embodiment, the quantity Q to be sensed is applied to the loop of the interferometer such that it is time varying and spatially asymmetrical.

Because the quantity Q is applied asymmetrically to the loop, variations in Q will affect each of the counterpropagating waves differently thereby producing a phase difference therebetween. However, if Q is a slowly varying quantity such as temperature, the value of Q may not change appreciably between the arrival times of the two counterpropagating waves at the point on the loop where Q is applied, so that each wave is affected substantially the same by Q. In such a case, the quantity Q is modulated onto a bias or carrier frequency which is rapidly time varying by a conventional modulator and applied to the loop at a point which is offset from the geometric center of the path between the light source and the detector. In the preferred embodiment, the modulated Q, i.e., q(t), is applied to the loop with a phase modulator which stretches the fiber in proportion to the amplitude of q(t).

Importantly, the invention utilizes the inherent stability and quieter operations of the closed loop interferometer to sense reciprocal quantities by causing them to produce nonreciprocal effects. The result is a quieter, more sensitive sensor which is better able to distinguish the effects of the desired quantity to be sensed from the effects of undesired quantities.

The delay line function of the closed loop increases the sensitivity to the quantity Q and allows a lower modulation frequency for the quantity Q when the invention is being used to sense slowly varying quantities such as temperature.

Accordingly, an object of the invention is a sensor which utilizes a closed loop fiber optic interferometer.

The invention and objects and features thereof will be more readily apparent from the following detailed description and appended claims when studied in light of the drawings.

Figure 1 is a schematic of a closed loop fiber optic interferometer such as is used in a rotation sensor.

Figure 2 is a schematic of an acoustic sensor employing a closed loop fiber optic interferometer in accordance with one embodiment of the invention.

Figure 3 is a schematic of an acoustic sensor employing a closed loop fiber optic interferometer in accordance with another embodiment of the invention.

Figure 4 is a plot of acoustic waves in the sensor of Figure 3.

Figure 5 is a schematic of a sensor which utilizes a closed loop fiber optic interferometer in accordance with the preferred embodiment of the invention.

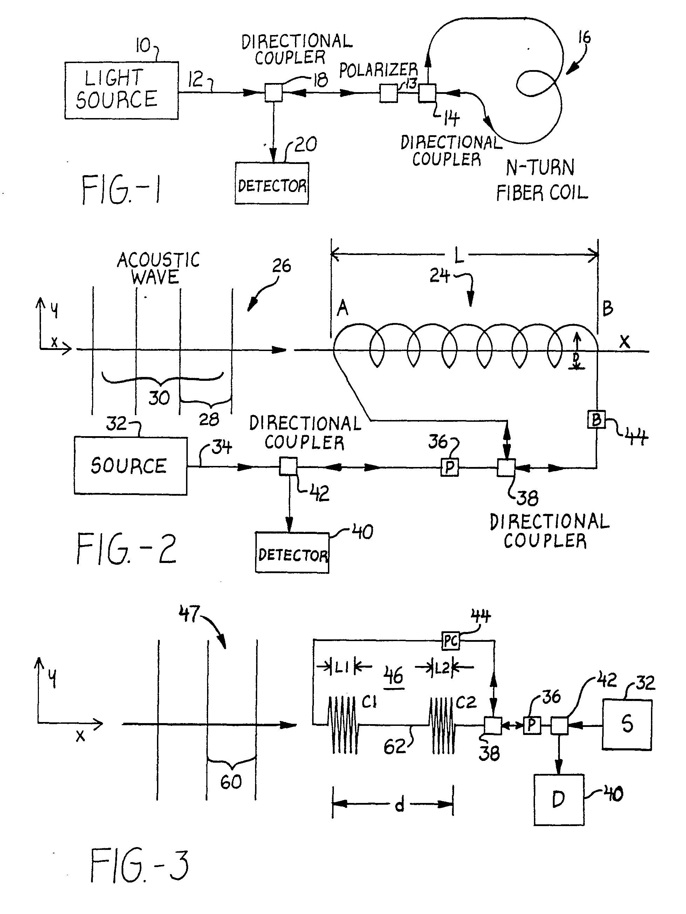

Referring now to the drawings, Figure 1 is a simplified schematic of a closed loop fiber optic interferometer such as is used in the rotation sensor disclosed in copending U.S. Patent Application serial number 319,311, filed November 9, 1981 (EP—A—75013) which is a continuation in part of U.S. Patent Application serial number 307,095 filed on September 30, 1981 which is a continuation in part of U.S. Patent Application serial number 249,714 filed on March 31, 1981 (US—A—4410275). A light source 10 generates a beam of light which is transmitted through an optical fiber 12 and polarizer 13 to a fiber optic directional coupler 14. A directional coupler could also be used to perform the beam splitting function. The light beam is split into two waves which propagate through the closed loop 16 in opposite directions as indicated by the arrows. After propagating through the loop 16 the two beams are recombined and pass through the optical fiber 12 to the polarizer 13 and then to a second fiber optic directional coupler 18 which directs the combined signals to a detector 20. The detector responds to the intensity of the combined waves which depends on the differences in phase between the two counterpropagating waves and provides an output signal indicative of the phase shift. Since the rotation of the fiber coil has a nonreciprocal effect on the counterpropagating waves, the detector gives a measure of the rotation. While not shown in Figure 1, the closed loop interferometer may also employ directional couplers, polarization controllers, phase modulators, and lock-in amplifiers as described in the co-pending application and as described by Bergh, Lefevre and Shaw in "All-single-mode fiber-optic Gyroscope with Long Term Stability", *Optics Letters*, Vol. 6, No. 10, Oct. 1981 and in "All-Single-mode Fiber-Optic Gyroscope", *Optics Letters*, Vol. 6. No. 4, April 1981.

The interferometer can take the form of an all fiber integrated device in which all components are constructed in a single monomode fiber. The phase modulators, if used, can provide bias which increases sensitivity and linearity of response.

Examples of normally differentially reciprocal effects which do not strongly affect the interferometer of Figure 1 are temperature, force, stress, pressure, displacement, strain, vibration and acoustic waves.

Figure 2 is a schematic of an acoustic wave sensor employing a closed loop interferometer in accordance with one embodiment of the invention. The acoustic wave sensor is similar in configuration to the rotation sensor of Figure 1. However, in this embodiment, the coil 24 is wound in an extended helical pattern having a longitudinal axis "x" lying along the direction of travel of an acoustic wave 26 to be sensed.

The sensor comprises a closed loop fiber optic waveguide 24 which is coiled into a number of turns. The diameter, D, of the turns, the number of the turns, N, and the spacing of the turns along the longitudinal axis x are selected to meet certain criteria. That criteria is that the acoustic wave 26 to be sensed must travel down the longitudinal axis x of the coil at the same velocity as that of a co-propagating optical signal travelling in the coil 24 from the A end to the B end would have. That is, as the light wave travels around the turns in the coil, it works its way toward the B end at a certain axial rate as if the light wave were climbing up the threads of a very finely threaded screw. This axial velocity for the light wave is much slower than the actual velocity of propagation in the fiber because there are many turns and each is approximately parallel to the planes 28 of the acoustic wave. Acoustic waves have planes of acoustic compression and rarifaction which are orthogonal to the direction of propagation of the acoustic wave. The planes 28, for a sound wave, represent peaks of higher pressure medium in the acoustic wave, and the spaces 30 represent areas of lower pressure medium.

In the embodiment of Figure 2, the coil is configured to maximize the overall global, non-reciprocal effect of the acoustic wave on the coil. The coil is configured with respect to the acoustic wave such that the effect of the acoustic wave on the coil is time varying and spatially non-uniform so as to cause a relative phase shift between the counterpropagating light waves. The diameters of the coil and the number of turns are selected such that a light wave travels the length of the coil 24 in a time $T_1$ which is equal to the time, $T_a$, for an acoustic wave to travel the axial length of helical coil 24. Accordingly, a light wave propagating through the coil from left to right experiences a constant pressure from the acoustic wave, whereas a light wave travelling from right to left experiences a continually varying effect.

That is, the number and diameter of spacing of the turns in the coil 24 are selected such that as a light wave enters the A end of the fiber, its speed of travel down the x axis toward the B end matches the speed of propagation of the acoustic wave 26 along the x axis toward the B end. Thus, if a pulse or burst of light enters the A end of the coil 24 when the A end is enveloped by the higher pressure region of a wave peak 28 of the acoustic wave, the pulse or burst of light will continually travel in fiber which is subjected to the same pressure from the same part of the acoustic wave 28. This pressure changes the geometric path length that the co-propagating wave travels from A to B because each segment of fiber that the light wave travels in is equally stretched or compressed by the pressure effects from the travelling acoustic wave. The situation is not the same for the counterpropagating wave however. The counterpropagating light wave travelling from the B end to the A end first encounters segments of fiber that are compressed by the peaks 28 of the acoustic wave and then encounters fiber segments that are stretched by the troughs 30. The geometric path that the counterpropagating light wave travels is thus alternately made longer then shorter by the acoustic wave. If the length L, of the coil 24 is an integer multiple of the wavelength of the acoustic wave, the net path length change for the counterpropagating wave will be zero. The result is a net phase shift between the two counterpropagating light waves which is linearly proportional to the amplitude of the acoustic wave 26 and to the length, L, of the coil 24. That is, for longer coil lengths, L, the acoustic wave has a greater interaction distance with the fiber in which the co-propagating light wave is travelling. The total increase in path length, and the resulting phase shift, therefore increases with greater interaction length, L.

The greatest directivity or discrimination of the coil 24 results when the coil length, L, is chosen to be some integer multiple of the acoustic wavelength because the net phase shift is then zero for the counterpropagating wave, i.e., the wave which is travelling in the fiber in an axial direction opposite the direction of propagation of the acoustic wave, resulting in the best performance of the sensor. However, L, can be any non-negligible fraction of the wavelength of the acoustic wave which is sufficient to create a discernible relative phase shift between the counterpropagating waves which is indicative of the amplitude of the acoustic wave. The frequency for an acoustic wave of unknown frequency propagating with a known velocity could be determined by using a variable length delay line and tuning the line for zero phase shift in the counterpropagating wave.

The counterpropagating light waves in the loop 24 are produced by a light source 32 coupling light waves into a fiber 34 which guides the waves through a polarizer 36 to a fiber optic directional coupler 38 coupled to the two ends of the coil 24. The light source 32 can have a coherence length which is very short. That is, as long as the coherence length of the source exceeds the differential path length through the coil caused by the acoustic wave, the two counterpropagating waves will still be coherent after travelling the length of the coil, and they can be successfully merged to interfere with each other. The interference is necessary to be able to determine the amount of the relative phase shift.

The fiber 34 is, in the preferred embodiment, a monomode fiber.

The polarizer 36 is bidirectional, and can be adjusted to pass only light of a predetermined polarization. The polarizer 36, is important in maintaining the reciprocal operational characteristic of the closed loop interferometer as is known in the art. The polarizer insures that the light going into the loop is in only one polarization. Any birefringence in the fiber of the loop will couple part of the energy to the orthogonal polarization mode where the propagation velocity is different from the velocity in the selected polarization. If the birefringence is not symmetric about the center of the geometric path, the counterpropagating waves will travel differing distances at the new velocities and will suffer different phase shifts. The polarizer only allows light of one polarization to enter the fiber and blocks all returning light energy in polarization modes other than the input polarization mode. Thus, the detector will only see light energy from the components of the counterpropagating waves which travelled through the loop in the selected polarization mode, and there will be no phase shift since both counterpropagating signals will have travelled the same geometric path length in the same polarization mode, i.e., at the same velocity.

The directional coupler 38 splits the polarized light wave travelling toward the loop from the polarizer 36 into two coherent light waves and couples each wave into one end of the coil 24, so that they counterpropagate. A beam splitter could be used in place of the directional coupler 38, but the directional coupler is the preferred embodiment since the fiber is continuous from the source 32 through the coupler and back to the detector. In contrast, a beam splitter joins separate fibers, the ends of which generate reflected waves. These reflected waves bounce back into the input fiber and interfere with the incoming light waves and can cause undesirable standing waves. The use of beam splitters is not a problem in terms of reflections where pulsed operation is used. In pulsed operation, the source 32 provides pulses separated by dark periods. By adjusting the length of fiber in the system and the pulse separation and duration, it is possible to cause the reflected signals to arrive at the detector during dark periods between the initial pulse and the returning combined pulse from the counterpropagating pulses.

The fiber optic directional coupler 38 also recombines the counterpropagating light signals after they have passed through the loop. The combined signal then is coupled into the input fiber 34 and passes through the polarizer 36 on its way to a photodetector 40. Between the polarizer 36 and the source 32, a second fiber optic directional coupler 42 is coupled to the input fiber 34. This second coupler 42 diverts part of the energy from the combined signal returning from the loop 24 into the input of the photodetector 40. The photodetector then generates a signal proportional to the intensity of the combined signal which can be interpreted to determine the relative phase shift. This is known in the art.

In the preferred embodiment, a polarization controller 44 is placed in the loop 24 to control the polarization of light signals travelling in the loop. This is desirable to prevent "signal fading" caused by the interaction of the polarizer 36 with birefringence zones in the loop 24. For example, if the polarizer only allows vertically polarized light in and out of the loop, and birefringence in the loop couples all the energy from the counterpropagating light signals into the horizontal polarization mode, then the polarizer 36 would block all output light and the detector would register a zero output. The structure of polarization controllers is known in the art. These devices are capable of taking input light at one polarization and shifting it to output light at any other selected polarization.

By properly adjusting the polarization controller 44 it is possible to insure that at least some of the light, and preferably most of the light, exits the loop in the polarization passed by the polarizer 36. That is, the polarization controller can be used to maximize the output signal from the detector. This prevents environmentally caused birefringence and birefringence in the fiber structure caused by residual stress from manufacturing processes from causing signal fadeout. The time varying and spatially non-uniform effect of the acoustic wave on counterpropagating optical waves in coil 24 varies the intensity of the recombined optical wave which can then be detected as a measure of the amplitude of the acoustic wave.

One possible use for the embodiment described in Figures 2 and 3 is as a direction finder for acoustic waves. This can be done by turning the loop longitudinal axis until the output signal is a maximum.

Since the length of the coil is directly proportional to the amount of total phase shift in the co-propagating light, the sensitivity of the sensor can be increased by increasing L, especially in increments of the wavelength of the acoustic wave 26.

Figure 3 is a schematic diagram of an acoustic sensor employing a closed loop interferometer in accordance with another embodiment of the invention. In this embodiment the coil 46 is separated into two separate, spaced groups of coils designated C1 and C2, one consisting of the first N/2 contiguous turns and the other consisting of the last N/2 contiguous turns of the optical fiber. The two groupings of coils are displaced along the x axis with respect to each other by a distance, d, such that the planes of the two groups of coils remain mutually parallel. The displacement, d, between the two groups of coils is chosen, in the preferred embodiment, to be an odd multiple of one quarter wavelength of the acoustic wave shown generally at 47. The total length of the fiber used to form the two groups of coils is such that the optical transit time through both coils is one-half the period of the acoustic wave frequency. In other embodiments, the distance d could be some other fraction of the wavelength of the acoustic wave if the sizes of the coils C1 and C2 are adjusted so that the optical transit times are the same fraction of the period of the acoustic wave that the distance d is to the wavelength of the acoustic wave. However, in these embodiments, the sensor is not as directionally selective. That is, in these alternative embodiments, the sensor will not discriminate as sharply between acoustic waves whose direction of propagation is parallel to the longitudinal axis x of the coils and acoustic waves whose direction of propagation is not parallel to the longitudinal axis of the coil.

The result of the foregoing structure is to cause a relative phase shift between counterpropagating light waves when an acoustic wave of the specified wavelength is propagating down the x axis. This phase shift is caused by the acoustic wave pressures acting on the counterpropagating light waves in a non-reciprocal fashion where such a wave would normally cause a reciprocal effect in an interferometer structure like the device of Figure 1.

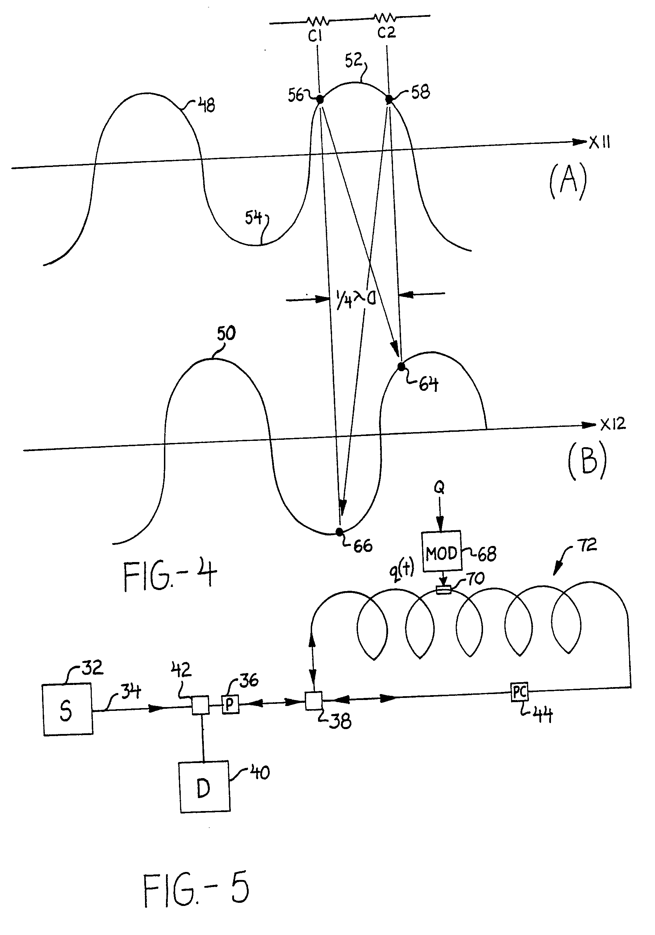

This non-reciprocal effect is illustrated in the plots of Figure 4 showing the acoustic waves in the first set of coils C1 and in the second set of coils C2 at times t1 and t2. In the preferred embodiment the distance d between the two groups of coils is selected to be 1/4 of the acoustic wave wavelength. The coils C1 and C2 are sized such that the optical transit time therethrough is equal to 1/4 of the period of the acoustic wave. The coils are also sized such that their lengths L1 and L2 are small compared to the wavelength of the acoustic wave. Again, as in the embodiment of Figure 1, the coils have a longitudinal axis x which is arranged to be parallel to the axis of propagation of the acoustic wave for maximum sensitivity.

The curves 48 and 50 represent the acoustic wave separated by 1/4th of the wavelength at the two instants in time t1 and t2 which instants in time are separated by 1/4 of the period of the acoustic wave. That is, the curve 48 represents the situation at the time t1, i.e., it shows how the coils C1 and C2 are enveloped by the peaks and troughs of acoustic pressure at the time t1 where the peaks and troughs of pressure are represented by the areas 52 and 54 respectively. Likewise, the curve 50 shows how the coils C1 and C2 are enveloped by the acoustic wave at the point in time t2 1/4 period later. At the time t1, the coil C1 is experiencing a substantially uniform acoustic pressure throughout the coil at the pressure level illustrated at 56. This results from the fact that the planes of the individual loops of the coil C1 are substantially parallel to the planes 60 of the acoustic wave 47 and from the fact that the length L1 of the coil C1 is small compared to the acoustic wavelength. The same observations are true for the coil C2 enveloped in the acoustic wave at the point 58 with the additional comment that the pressure at 58 is equal to the pressure at 56. This is because the coils C1 and C2 are separated by 1/4 of the acoustic wavelength and the instant of time t1 happens to be a time when the wave peak is exactly centered between the coils. At some other later or earlier time, this would not be the case. The principal at work in the embodiment of Figure 3 holds true for any time t however.

The positive compression effects acting uniformly throughout the coils C1 and C2, change the geometric path length uniformly in both the coils C1 and C2. The co-propagating light signal in the coil C1 and the counterpropagating light signal in the coil C2 at the time t1 thus experience equal changes in their geometric path lengths and, therefore, the transit time for each light signal through the whole loop is changed. Because the coils C1 and C2 are sized such that it takes each of the counterpropagating light signals 1/4 period of the acoustic wave to propagate through each coil, the co-propagating light signal in C1 stays in the coil C1 until the time t2, at which time it exits on the fiber segment 62. An extremely short time later this co-propagating light signal enters the coil C2 which is immersed in the acoustic wave as shown at 64 on curve 50 in Figure 4(B). Likewise, the counterpropagating wave in the coil C2 at the time t1 stays in C2 until the time t2 and then travels through the segment 62 and enters the coil C1. Thus, at the time t2, the coils C1 and C2 are immersed in acoustic pressure at the corresponding amplitudes as shown by points 64 and 66, respectively.

The co-propagating light signal which was in coil group C1 at time t1 and experienced the pressure at 56 in Figure 4(A) is now in coil group C2 at time t2 and experiences the same positive compression effects from the acoustic wave 47 as shown at 64 in Figure 4(B). These compressive effects change the geometric path length through the coil C2 in the same amount and in the same sign as occurred in the coil C1 at the time t1. Thus the transit time through the coil C2 is changed and is of the same sign as the change in transit time experienced in the coil C1 at the time t1. The overall change in transit time for the co-propagating signal is additive and non-zero therefore.

However, the counterpropagating light signal which was in coil group C2 at t1 experiences the pressure at 58 in Figure 4(A) and then travels to the left and is in coil C1 at time t2 where it experiences an equal and opposite pressure illustrated at 66 in Figure 4(B). Thus, the counterpropagating light signal experiences a path length change in the coil C1 which is equal and opposite to the path length change it experienced in the coil C2. Thus, the change in transit time caused by the coil C2 is cancelled by the change in transit time caused by the coil C1, and the counterpropagating light signal will have a net change in transit time through the coil 46 of zero.

In summary, the effect on the wave propagating from coil C1 to C2 is reinforcing while the effect on the signal propagating from coil C2 to coil C1 is offsetting. Accordingly, the counterpropagating waves contain a relative phase difference when recombined after propagating through the two groups of coils. This phase difference is then detected and can be interpreted linearly to determine the amplitude of the acoustic wave.

If the optical transit time through each coil and the separation of the coils is other than 1/4 period and 1/4 wavelength respectively, the sensor will still work to sense the presence of waves but the counterpropagating wave will not have a net zero transit time change. The response of the sensor in this case will be non-linear.

Both the sensors of Figure 2 and 3 have a certain bandwidth in which they are useful. The center frequency of each bandwidth is the frequency having the wavelength which causes a net zero phase shift in the counterpropagating light signal. At other wavelengths, the response falls off somewhat because of various effects.

In the embodiments of Figures 2 and 3, the optical coil interferometer also functions as the sensor for the measured acoustical wave. Further, both embodiments require that the coils be designed for a particular frequency of acoustic wave for optimal operation unless a variable coil length can be achieved such as by an infinitely variable delay line as is known in the art. The details of the structure of delay lines that could be used to give infinitely variable delays are given in an article entitled "Fibre-Optic Variable Delay Lines" published in *Electronics Letters* of November 11, 1982, Vol. 18, No. 23, at pages 999—1000. Such variable delay lines could be used for the coil 24 in Figure 2 or the coils C1 and C2 in Figure 3 to change the center frequency of the sensor bandwidth.

Figure 5 is a schematic diagram of another embodiment of a sensor which utilizes the optical coil solely as an interferometer and delay line. In this embodiment, the quantity to be sensed, designated as Q, is applied to a modulator 68 which generates a time-varying signal q(t) consisting of either a signal q(t), which varies directly with the sensed quantity Q, or a carrier signal having a high frequency which is modulated by the quantity Q. Any suitable structure for the modulator 50 will suffice for purposes of the invention, and the signal q(t) could be the quantity Q itself or an electrical signal proportional thereto.

The signal q(t) is applied to a transducer 70 which can be a polarization controller or any other device which can affect the optical transmission properties of the fiber at the location of the transducer 70. In the preferred embodiment, the signal q(t) is a carrier or bias frequency amplitude modulated with the quantity Q. In the preferred embodiment, the transducer 70 is a phase modulator. The transducer must be located at a spot that is offset from the midpoint on the geometric path of the loop. The signal q(t) must be time-varying at a rate which is more rapid than the rate of change that is naturally filtered out by the structure and operation of closed loop fiber optic interferometers. The signal q(t) exerts a spatially non-uniform effect on the coil 72, as will be explained more fully below.

The structural details of the transducer 70 and the modulator 68 are not critical to the invention. The transducer 70 can be any device which can cause a change in the birefringence of the fiber at the location of the transducer 70 or elsewhere, such as a device to put bending or other stress on the fiber in response to q(t). Further, the transducer 70 can be any device which can change the velocity of light propagating through the location of the transducer 70. Such a velocity modulating device could be any structure to convert q(t) to a physical change in the fiber transverse dimension at the location of the transducer. This changes the velocity of propagation of light signals through the region of changed transverse dimension by the waveguide effect. In another embodiment, the transducer 70 could be a polarization controller for changing the polarization of the counterpropagating light signals at the location of the transducer 70 in response to q(t).

In the preferred embodiment, the transducer 70 is a phase modulator which converts the signal q(t) to changes in the path length of the fiber optic waveguide at the location of the transducer 70 in the loop. That is, the fiber is stretched in the transducer 70 in accordance with the amplitude of the signal q(t). A suitable structure for such a phase modulator is a drum of piezoelectric material with the fiber of the coil 72 wound around the drum. A driving electrical signal such as the signal q(t) then is applied to the piezoelectric material and causes it to expand and contract radially in accordance with the magnitude of the driving signal. This radial expansion causes the fiber wrapped around the drum to be stretched.

In an alternative embodiment, the signal q(t) could be used to control the adjustment of a polarization controller as the transducer 70. The structural details of a polarization controller that might be adapted to perform such a function in all three embodiments are found in an article entitled "Single Mode Fibre Fractional Wave Devices and Polarization Controllers" by H. C. Lefevre published in *Electronics Letters*, Vol. 16, No. 20 and in U.S. patent application serial number 183,975 filed September 4, 1980 (US—A—4389090).

The function and structural details of the source 32, the coupler 42, the detector 40, the polarizer 36, the fiber optic directional couplers 38 and 42 and the polarization controller 44 are the same in the embodiment of Figure 5 as in the embodiments of Figures 2 and 3. Beam splitters could be used in the three embodiments but the reflections caused by these beam splitters would render pulsed operation more desirable as discussed above with reference to the embodiment of Figure 2. Fiber optic directional couplers are the preferred embodiment in all three embodiments of the invention. The details of the structure and operation of the polarizer 36 are given in an article entitled "Single Mode Fiber Optic Polarizer" published in *Optics Letters*, Vol. 5, No. 11 at pp. 479—81 in November, 1980. The details of the structure and operation of the directional couplers 42 and 38 are given in an article entitled "Analysis of a Tunable Single Mode Optical Fiber Coupler" by Digonnet and Shaw published in the *IEEE Journal of Quantum Electronics*, Vol. QE-18, No. 4, pp. 746—754 dated April, 1982. The details are also disclosed in U.S. Patent application serial number 300,955 filed on September 10, 1981 (US—A—4536058) which is a continuation in part of U.S. patent application serial number 139,511 filed on April 11, 1980 (US—A—4493528).

The operation of the embodiment of Figure 5 is as follows. The light source 32 supplies a light signal which is coupled into the single mode optical fiber 34 and guided through the directional coupler 42 and the polarizer 36 to the directional coupler 38. The polarizer 36 causes only light having a selected polarization to be passed through the polarizer regardless of whether the light is travelling toward the loop 72 or away from the loop 72. The directional coupler 38 splits the light signal into two coherent light signals counterpropagating around the loop and combines the returning counterpropagating light signals into one light signal travelling toward the source 32 in the fiber 34. The polarization controller 44 allows selection of the polarization for light travelling in the loop in either direction. The coupler 42 diverts part of the light travelling toward the source into the input of the photodetector 40 where it is converted to an electrical signal based upon its amplitude squared, i.e., its intensity. Of course the amplitude of the combined signals which have counterpropagated in the loop 72 depends upon the relative phase shift between these signals caused by the optical conditions in the loop. The counterpropagating light signals in the loop 72 have their relative phases shifted by the action of the transducer 70. The quantity Q can be either a rapidly changing quantity or a slowly changing quantity. If the quantity Q is rapidly changing, it can be applied directly to the transducer 70 which can convert it to a time varying shift in the path length of the fiber at the transducer 70 or a change in the birefringence of the fiber at the transducer 70.

If the transducer 70 changes the path length in the transducer 70 at a rapid, time varying rate, the counterpropagating light signals travel different path lengths through the loop and end up shifted in phase relative to each other. This is because they arrive at the transducer 70 at different times due to its off center location. Because the path length through the transducer 70 will be different at the two different times when the counterpropagating light signals arrive at the transducer, the two counterpropagating signals will have two different transit times through the loop 72. They will therefore arrive at the directional coupler 38 at different times and thus be shifted in phase relative to each other.

The combined signal will have an amplitude dependent upon the relative phase shift. The amplitude of the combined light signal can be interpreted to find the quantity Q because the relative phase shift is linearly related to Q.

If Q is a slowly varying differentially reciprocal quantity, such as temperature or pressure, Q will have to be modulated upon a rapidly time varying carrier signal applied asymmetrically because, as is well known in the art, closed loop fiber optic interferometers are ordinarily not sensitive to slowly time varying reciprocal effects. In fact, this is the great advantage of closed loop interferometers because this quality makes them very quiet and stable.

When Q is modulated onto a bias or carrier frequency such as by amplitude or frequency modulation, and the transducer 70 is a phase modulator, the above discussion still holds true. If amplitude modulation is used, the path length in the transducer will be changing sinusoidally at the bias or carrier frequency but the amplitude of the path length swings will vary with Q. Therefore the relative phase shift caused by the transducer 70 will vary sinusoidally. Further, the amplitude of the sinusoidal relative phase shift, i.e., the amplitude envelope of the sinusoidal swings in relative phase shift will be the quantity Q. The envelope will vary over time as Q varies over time.

If the transducer changes the birefringence of the fiber at the location of the transducer 70, the relative phase shift is caused by coupling of the light from one polarization mode to the other. Birefringence is the property of optical fibers which causes light propagating in them in different polarization modes to propagate at different velocities. If the transducer 70 is changing the birefringence of the fiber at the location of the transducer 70 in proportion to the signal q(t) or Q, the transducer will be changing the relative phase shift between the counterpropagating signals. This is because the transducer will be controlling the amount of energy travelling in the slow mode versus the amount of energy travelling in the fast mode. That is, when light travelling in a waveguide in one polarization mode encounters birefringence, some of the light energy will be coupled into the orthogonal polarization mode and will travel thereafter in the different velocity for the new polarization mode. If the amount of birefringence is a function of q(t), then the quantity Q can be determined by the amount of energy in the counterpropagating light signals propagating in the orthogonal polarization mode from the polarization established by the polarizer 36. This can be determined from the amplitude of the combined signal from the counterpropagating signals in the orthogonal polarization mode. In the embodiment of Figure 5 to determine the amplitude of the combined signal from the orthogonal mode, another directional coupler would have to be added between the polarizer and the coupler to direct some of the returning energy to a polarizer tuned to the orthogonal mode and another photodetector would have be coupled to the output of the second polarizer.

The method of sensing acoustic or other waves comprises guiding counterpropagating light signals through a coil of a closed loop fiber optic interferometer which is wound and arranged in a predetermined way. That predetermined way is to arrange the coil so that the subject acoustic or other wave propagates down the longitudinal axis of the coil at the same rate that a co-propagating light wave progresses down the longitudinal axis of the coil. The phase difference is then detected between the counterpropagating light signals in the coil as the subject wave propagates through it.

More specifically the method comprises generating a light signal and polarizing the light signal in a selected polarization. The polarized light is then split into two light signals which are then counterpropagated through the helically coiled loop of a closed loop fiber optic interferometer which loop is arranged with its longitudinal axis parallel to the direction of propagation of the subject wave. The loop is coiled and sized such that the co-propagating light signal which travels through the fiber is substantially uniformly affected in terms of phase shift by the subject wave while the counterpropagating wave which travels through the fiber is not uniformly affected in terms of phase shift by the subject wave. The phase difference is then detected.

A method for sensing a phenomenon or quantity Q consists of guiding counterpropagating light signals through a coil of closed loop fiber optic interferometer. The quantity Q is sensed by a modulator which converts the quantity into a signal q(t) which varies with Q. The signal q(t) may be Q itself or an electrical signal varying linearly with Q in some applications. The signal q(t) is applied to the coil of the fiber optic interferometer at a location offset from the center of the geometric path of the coil such that the optical transmission characteristics of the fiber are altered at that location. The relative phase shift between the counterpropagating light signals is then detected.

The signal q(t) can be applied so as to alter the birefringence in proportion to q(t) at the location of application of q(t) or it can be applied so as to alter the velocity of propagation in the fiber in accord with q(t) at the location of application. Further q(t) can be applied such that the polarization of light passing through the location in the coil where q(t) is applied is altered proportionally to q(t). The preferred method is to alter the geometric path length of one counterpropagating signal relative to the other in accord with q(t).

All these methods should include the step of polarizing the light of the counterpropagating light signals in the same direction prior to entry into the coil and filtering out all returning counterpropagating light not of the same polarization as the polarization of the counterpropagating light signals coupled into the loop. This coupling should be done prior to detecting the relative phase shift between the returning counterpropagating light signals.

All these methods can also include the step of controlling and adjusting the polarization of the counterpropagating light signals in the loop to any selected polarization.

All the methods of sensing the quantity Q can also include the step of modulating the quantity Q onto a bias or carrier frequency to generate a signal q(t) before applying q(t) to the loop.

The quantity could be applied directly to the transducer and the rate of change sensed. For example, the quantity Q may be temperature of an environment and the signal q(t) would be a time varying measure of the temperature. The signal q(t) is then applied asymmetrically to one or more small segments in the optical coil to affect the interferometer and thus generate a detectable variation in the recombined optical signals. In addition to the devices described above, the transducer 70 may also be electro-optical, piezoelectric, or magnetostrictive.

There have been described several embodiments of a sensor which either includes or utilizes a closed loop optical interferometer for detecting a sensed quantity, Q. In each of the embodiments, the sensed quantity is spatially non-uniform with respect to the closed loop. The entire coil can be employed as the sensor element, or the quantity can be applied at one or more points asymmetrically located on the coil.

Although the invention has been described in terms of a preferred embodiment, it will be apparent to those skilled in the art that numerous modifications can be made without departing from the scope of the claims appended hereto. Such modifications are intended to be included within the scope of the claims.

**Claims**

1. An apparatus comprising a closed loop optical interferometer for sensing a time-varying quantity which produces reciprocal effects on a differential scale in an optical fiber, characterized by:

a closed loop (24, 46, 72) of optical fiber for propagating first and second lightwaves in opposite directions about said loop, said loop (24, 46, 72) arranged such that, in use, the quantity to be sensed is applied at a point or at points that are offset from the midpoint of the path around the loop such that the parts of the counterpropagating lightwaves arriving simultaneously at the detector (40) have been influenced by different values of said quantity, thereby making the loop (24, 46, 72) nonreciprocal on a global scale with respect to the sensed quantity to cause a phase shift between said counterpropagating lightwaves;

a light source (32) for generating said lightwaves;

a coupler (38) for splitting a light signal from said source (32) into said first and second lightwaves and for optically coupling said first and second lightwaves to said loop (24, 46, 72) such that said first and second lightwaves counterpropagate through said loop (24, 46, 72); and

a detector (40) for detecting the phase difference between said first and second counterpropagating lightwaves.

2. An apparatus as defined in Claim 1, characterized in that said detector (40) detects said phase difference by detecting the intensity of a combined signal resulting from the interference of said first and second counterpropagating lightwaves.

3. An apparatus as defined in either of Claims 1 or 2, characterized in that said source (32) generates light of a selected polarization.

4. An apparatus as defined in any one of Claims 1—3, characterized in that said source (32) and said detector (40) are coupled to a polarizer (36) which prevents substantially all light of other than a selected polarization from passing in either direction.

5. An apparatus as defined in any one of Claims 1—4, characterized in that said loop (24, 46, 72) includes a polarization controller (44) to control the polarization of said first and second counterpropagating lightwaves.

6. An apparatus as defined in any one of Claims 1—5, characterized in that said loop (24, 46, 72) has plural turns to form a coil.

7. An apparatus as defined in Claim 6, for sensing an acoustic wave (26, 47) which has compression type wave fronts (28) and rarefaction type wave fronts (30), said apparatus characterized in that said coil (24, 46) is configured such that one of the counterpropagating lightwaves is exposed substantially exclusively to either compression type wave fronts (28) or rarefaction type wave fronts (30) of said acoustic wave (26, 47) during propagation through said coil (24, 46), and the other of the counterpropagating lightwaves is exposed to both compression (28) and rarefaction (30) type wave fronts of said acoustic wave (26, 47) during propagation through said coil (24, 46).

8. An apparatus as defined in Claim 7, characterized in that said coil (24) is formed by an optical fiber having a plurality of turns, the diameter of said turns and the spacing therebetween selected such that the component of the acoustic wave (26) which propagates down the longitudinal axis (X) of the coil (24) travels at substantially the same axial rate that said first lightwave travels down said axis (X) during propagation through said coil (24).

9. An apparatus as defined in Claim 8, characterized in that said spacing is between adjacent turns of said coil (24).

10. An apparatus as defined in any one of Claims 7—9, characterized in that said turns are substantially perpendicular to the direction of propagation (X) of the acoustic wave (26, 47).

11. An apparatus as defined in Claim 7, characterized in that said coil (46) is comprised of first and second optically-interconnected coils (C1, C2) of optical fiber.

12. An apparatus as defined in Claim 11, characterized in that said first coil (C1) is spatially separated from said second coil (C2), such that said first lightwave propagates first through said first coil (C1) and then through said second coil (C2), the spatial separation (d) between said coils (C1, C2) and the diameter and number of turns in each coil (C1, C2) selected such that said first lightwave is exposed to substantially the same portion of the acoustic wave (47) during propagation through said second coil (C2) as during propagation through said first coil (C1).

13. An apparatus as defined in Claim 12, characterized in that each of said coils (C1, C2) comprises a number of turns of said optical fiber about a longitudinal axis (X), said turns spaced along said axis (X) such that said counterpropagating lightwaves in said coils (C1, C2) travel in planes substantially parallel to the planes (60) of the acoustic wave (47), and the optical transit time between corresponding portions of the coils (C1, C2) is approximately one-quarter of the period of said acoustic wave (47).

14. An apparatus as defined in Claim 12, characterized in that each of said coils (C1, C2) is configured such that the transit time therethrough for said lightwave is substantially equal to some predetermined fraction of the period of the acoustic wave (47) and wherein the coils (C1, C2) are separated by a distance (d) approximately equal to the same fraction of the wavelength of the acoustic wave (47) that the transit time in each coil (C1, C2) is of the period of the acoustic wave (47).

15. An apparatus as defined in either of Claims 13 or 14, characterized in that a link of transfer optical fiber (62) is arranged between said coils (C1, C2) such that the optical transit time of said lightwave in said link of transfer optical fiber (62) is substantially faster than the transit time of said acoustic wave (47) between said coils (C1, C2).

16. An apparatus as defined in Claim 14, characterized in that said spatial separation (d) between said coils (C1, C2) is equal to approximately one-quarter of the wavelength of the acoustic wave (47).

17. An apparatus as defined in Claim 14, characterized in that each of said coils (C1, C2) is configured such that the transit time of said counterpropagating lightwaves through each of said coils (C1, C2) is approximately equal to the time required for the acoustic wave (47) to travel a distance equal to one-quarter of a wavelength of said acoustic wave (47).

18. An apparatus as defined by any one of Claims 1—5, further characterized by:

a modulator (68) for sensing a quantity Q, and transforming Q into a time-varying signal q(t); and

a transducer (70) for converting the signal q(t) to a corresponding change in the optical transmission properties of said optical fiber loop (72).

19. An apparatus as defined in Claim 18, characterized in that said transducer comprises a phase modulator (70) located at a location on said loop (72) which is offset from the center of the optical path formed by said loop (72) such that the detected phase difference between said counterpropagating lightwaves varies in response to the quantity Q.

20. An apparatus as defined in either of Claims 18 or 19, further characterized by a polarizer (36) for causing said light source to couple light of a selected polarization into said loop (72).

21. An apparatus as defined in any one of Claims 18—20, characterized in that said signal q(t) is the quantity Q modulated onto a bias signal.

22. An apparatus as defined in any one of Claims 18—21, characterized in that said signal q(t) varies in amplitude.

23. An apparatus as defined in any one of Claims 18—22, characterized in that said transducer (70) causes phase modulation by stretching the optical fiber such that each of said first and second lightwaves travels a different optical path around said loop (72) than each would travel in the absence of said signal q(t).

24. An apparatus as defined in any one of Claims 18, 19, 20, 22 or 23, characterized in that Q is rapidly time-varying and q(t) is directly proportional to Q.

25. An apparatus as defined in any one of Claims 18—24, characterized in that said transducer (70) changes the birefringence of said fiber in response to q(t).

26. An apparatus as defined in any one of Claims 18—24, characterized in that said transducer (70) changes the velocity of propagation of said first and second lightwaves in response to q(t).

27. An apparatus as defined in any one of Claims 18—26, characterized in that said transducer (70) shifts the relative phase of said first and second light signals in response to q(t).

28. An apparatus as defined in Claim 20, characterized in that said transducer (70) changes the birefringence of said fiber in response to q(t), thereby causing coupling of a portion of said lightwave to the polarization mode orthogonal to said selected polarization mode.

29. An apparatus as defined in Claim 28, further characterized in that the detector (40) independently detects light of said selected polarization mode and said orthogonal polarization mode.

30. A method of sensing a time-varying quantity which produces reciprocal effects on a differential scale in an optical fiber comprising the steps of:

utilizing an optical fiber interferometer comprised of a loop (24, 46, 72) of optical fiber which forms an optical path having an optical path length, a light source (32) for producing light, a coupling device (38) for splitting the light into first and second counterpropagating lightwaves which traverse said optical path in opposite directions and a detector (40) for detecting the phase difference between the lightwaves after traversing the optical path length, said method characterized by the steps of

exposing said counterpropagating lightwaves to the quantity to be sensed;

applying said quantity at a point or at points that are offset from the midpoint of the path around the loop such that the parts of the counterpropagating lightwaves arriving simultaneously at the detector (40) have been influenced by different values of said quantity, thereby making the interferometer nonreciprocal on a global scale with respect to the sensed quantity to cause a phase shift between said counterpropagating waves which is indicative of the quantity to be sensed; and

detecting the phase shift between the counterpropagating waves.

31. A method of sensing as defined in Claim 30, wherein said quantity to be sensed comprises an acoustic wave (26, 47) which has compression type wave fronts (28) and rarefaction type wave fronts (30), further characterized by the steps of:

exposing a portion of said first counterpropagating lightwave substantially exclusively to either compression type wave fronts (28) or rarefaction type wave fronts (30) of said acoustic wave (26, 47); and

exposing the portion of said second counterpropagating lightwave which corresponds to said portion of said first counterpropagating lightwave to both compression (28) and rarefaction (30) type wave fronts of said acoustic wave (26, 47).

32. A method of sensing an acoustic wave (26, 47) as defined by Claim 31, characterized in that said acoustic wave (26, 47) provides a reinforcing effect on said portion of said first counterpropagating lightwave, and wherein said acoustic wave (26, 47) provides an offsetting effect on said corresponding portion of said second counterpropagating lightwave.

33. A method of sensing as defined in either Claim 31 or 32, additionally characterized by:

guiding said counterpropagating lightwaves through at least one coil (24) in said loop of optical fiber, said coil having a plurality of turns;

positioning said coil (24) such that the planes formed by said turns are substantially perpendicular to the direction of propagation (X) of said acoustic wave (26); and

spacing the turns such that the distance between two of said turns matches (a) the propagation time of one of the counterpropagating lightwaves along the direction of propagation of the acoustic wave (X) between said two turns with (b) the propagation time of the acoustic wave (26) along the direction of propagation (X) of the acoustic wave (26) between said two turns.

34. A method of sensing as defined in Claim 33, characterized in that said two turns are adjacent.

35. A method of sensing as defined in either Claim 31 or 32, characterized by:

guiding said counterpropagating lightwaves through said optically-interconnected coils (C1, C2) in said loop of optical fiber; and

spatially separating the two coils along the direction of propagation (X) of the acoustic wave (47) by a distance (d) which is substantially equal to one-quarter of the wavelength of the acoustic wave (47).

36. A method of sensing as defined in Claim 35, additionally characterized by sizing the circumference of each coil (C1, C2) and selecting the number of turns of optical fiber in each coil such that the propagation time of the counterpropagating lightwaves through each coil is substantially equal to one-quarter of the period of the acoustic wave.

37. A method of sensing an acoustic wave (26, 47) as defined in Claim 32, characterized in that said reinforcing effect is created by exposing said portion of said first counterpropagating lightwave to substantially the same one-quarter of a cycle of said acoustic wave (26, 47) more than one time.

38. A method of sensing a quantity as defined in Claim 30, further characterized by the steps of:

generating a signal q(t) in response to the quantity being sensed; and

converting the signal q(t) to a corresponding change in the optical properties of the loop (72) at a location on said loop which is offset from the midpoint of said optical path length such that said phase difference varies in response to the quantity Q.

**Patentansprüche**

1. Vorrichtung mit einem optischen Interferometer mit geschlossener Schleife zur Erfühlung einer sich zeitlich ändernden Größe, welche reziproke Effekte auf einer Differentialskala in einer optischen Faser erzeugt, gekennzeichnet durch

eine geschlossene Schleife (24, 46, 72) einer optischen Faser zur Fortpflanzung erster und zweiter Lichtwellen in entgegengesetzten Richtungen um die Schleife herum, wobei die Schleife (24, 46, 72) derart ausgebildet ist, daß im Gebrauch die zu erfühlende Größe an einem Punkt oder an Punkten angelegt wird, die vom Mittelpunkt des Pfades um die Schleife herum derart versetzt sind, daß die Teile der gegenläufigen Lichtwellen, die gleichzeitig am Detektor (40) eintreffen, durch unterschiedliche Werte der Größe beeinflußt worden sind, wodurch die Schleife (24, 46, 72) nichtreziprok auf einer Globalskala mit Bezug auf die abgefühlte Größe gemacht wird, um eine Phasenverschiebung zwischen den gegenläufigen Lichtwellen zu bewirken;

eine Lichtquelle (32) zur Erzeugung der Lichtwellen;

einen Koppler (38) zur Aufteilung eines Lichtsignals aus der Quelle (32) in die erste und die zweite Lichtwelle und zur optischen Kopplung der ersten und zweiten Lichtwelle mit der Schleife (24, 46, 72), und zwar derart, daß sich die ersten und zweiten Lichtwellen durch die Schleife (24, 46, 72) gegenläufig fortpflanzen; und

einen Detektor (40) zur Ermittlung der Phasendifferenz zwischen der ersten und zweiten gegenläufigen Lichtwelle.

2. Vorrichtung nach Anspruch 1, dadurch gekennzeichnet, daß der Detektor (40) die Phasendifferenz dadurch ermittelt, daß er die Intensität eines kombinierten Signals detektiert, das sich aus der Interferenz der ersten und zweiten gegenläufigen Lichtwelle ergibt.

3. Vorrichtung nach einem der Ansprüche 1 oder 2, dadurch gekennzeichnet, daß die Quelle (32) Licht mit einer ausgewählten Polarisierung erzeugt.

4. Vorrichtung nach einem der Ansprüche 1 bis 3, dadurch gekennzeichnet, daß die Quelle (32) und der Detektor (40) mit einem Polarisator (36) gekoppelt sind, der im wesentlichen alles Licht mit Ausnahme des Lichts einer ausgewählten Polarisation daran hindert, in irgendeiner Richtung hindurchzutreten.

5. Vorrichtung nach einem der Ansprüche 1 bis 4, dadurch gekennzeichnet, daß die Schleife (24, 46, 72) einen Polarisationskontroller (44) zur Kontrollierung der Polarisation der ersten und zweiten gegenläufigen Lichtwellen umfaßt.

6. Vorrichtung nach einem der Ansprüche 1 bis 5, dadurch gekennzeichnet, daß die Schleife (24, 46, 72) zur Bildung einer Spule mehrere Windungen besitzt.

7. Vorrichtung nach Anspruch 6 zum Abfühlen einer akustischen Welle (26, 47), welche Wellenfronten (28) vom Kompressionstyp und Wellenfronten (30) vom Verarmungstyp aufweist, wobei die Vorrichtung dadurch gekennzeichnet ist, daß die Spule (24, 46) derart gestaltet ist, daß eine der gegenläufigen Lichtwellen im wesentlichen ausschließlich entweder den Wellenfronten (28) vom Kompressionstyp oder den Wellenfronten (30) vom Verarmungstyp der akustischen Welle (26, 47) während der Fortpflanzung durch die Spule (24, 46) ausgesetzt ist, und daß die andere der gegenläufigen Lichtwellen sowohl den Wellenfronten (28) vom Kompressionstyp als auch den Wellenfronten (30) vom Verarmungstyp der akustischen Welle (26, 47) während der Fortpflanzung durch die Spule (24, 46) ausgesetzt ist.

8. Vorrichtung nach Anspruch 7, dadurch gekennzeichnet, daß die Spule (24) durch eine optische Faser geformt ist, welche eine Vielzahl von Windungen aufweist, daß der Durchmesser der Windungen und der Abstand zwischen ihnen derart gewählt ist, daß die Komponente der akustischen Welle (26), die sich nach unten entlang der Längsachse (X) der Spule (24) fortpflanzt, mit im wesentlichen der gleichen Axialrate wandert wie die erste Lichtwelle die Achse (X) während der Fortpflanzung durch die Spule (24) hinunterwandert.

9. Vorrichtung nach Anspruch 8, dadurch gekennzeichnet, daß der Abstand zwischen benachbarten Windungen der Spule (24) vorliegt.

10. Vorrichtung nach einem der Ansprüche 7 bis 9, dadurch gekennzeichnet, daß die Windungen im wesentlichen senkrecht zur Fortpflanzungsrichtung (X) der akustischen Welle (26, 47) angeordnet sind.

11. Vorrichtung nach Anspruch 7, dadurch gekennzeichnet, daß die Spule (46) aus ersten und zweiten optisch miteinander verbundenen Spulen (C1, C2) von optischer Faser besteht.

12. Vorrichtung nach Anspruch 11, dadurch gekennzeichnet, daß die erste Spule (C1) räumlich von der zweiten Spule (C2) derart getrennt ist, daß die erste Lichtwelle sich durch die erste Spule (C1) fortpflanzt und dann durch die zweite Spule (C2), daß die räumliche Trennung (d) zwischen den Spulen (C1, C2) und der Durchmesser und die Anzahl der Windungen in jeder Spule (C1, C2) derart ausgewählt sind, daß die erste Lichtwelle im wesentlichen dem gleichen Abschnitt der akustischen Welle (47) während der Fortpflanzung durch die zweite Spule (C2) ausgesetzt ist, wie während der Fortpflanzung durch die erste Spule (C1).

13. Vorrichtung nach Anspruch 12, dadurch gekennzeichnet, daß jede der Spulen (C1, C2) eine Anzahl von Windungen der optischen Faser um eine Längsachse (X) umfaßt, daß die Windungen entlang der Achse (X) derart im Abstand angeordnet sind, daß die gegenläufigen Lichtwellen in den Spulen (C1, C2) in Ebenen wandern, die im wesentlichen parallel zu den Ebenen (60) der akustischen Welle (47) liegen, und daß die optische Transitzeit zwischen entsprechenden Abschnitten der Spulen (C1, C2) ungefähr ein Viertel der Periode der akustischen Welle (47) beträgt.

14. Vorrichtung nach Anspruch 12, dadurch gekennzeichnet, daß jede der Spulen (C1, C2) derart gestaltet ist, daß die Transitzeit für die Lichtwelle durch sie hindurch im wesentlichen gleich einem vorbestimmten Bruchteil der Periode der akustischen Welle (47) ist, und daß die Spulen (C1, C2) mit einem Abstand (d) voneinander getrennt sind, der im wesentlichen gleich dem gleichen Bruchteil der Wellenlänge der akustischen Welle (47) ist, bei der die Transitzeit in jeder Spule (C1, C2) die Periode der akustischen Welle (47) ist.

15. Vorrichtung nach einem der Ansprüche 13 oder 14, dadurch gekennzeichnet, daß eine Verbindung einer optischen Transferfaser (62) zwischen den Spulen (C1, C2) derart angeordnet ist, daß die optische Transitzeit der Lichtwelle in dem Verbindungsglied der optischen Transferfaser (62) wesentlich schneller ist als die Transitzeit der akustischen Welle (47) zwischen den Spulen (C1, C2).

16. Vorrichtung nach Anspruch 14, dadurch gekennzeichnet, daß die räumliche Trennung (d) zwischen den Spulen (C1, C2) gleich ungefähr einem Viertel der Wellenlänge der akustischen Welle (47) ist.

17. Vorrichtung nach Anspruch 14, dadurch gekennzeichnet, daß jede der Spulen (C1, C2) derart gestaltet ist, daß die Transitzeit der gegenläufigen Lichtwellen durch jede der Spulen (C1, C2) ungefähr gleich derjenigen Zeit ist, welche die akustische Welle (47) dazu benötigt, eine Strecke zu durchlaufen, die gleich einem Viertel der Wellenlänge der akustischen Welle (47) ist.

18. Vorrichtung nach einem der Ansprüche 1 bis 5, ferner gekennzeichnet durch:
einen Modulator (68) zur Abfühlung einer Größe Q und zur Umwandlung von Q in ein zeitvariables Signal q(t); und
einen Wandler (70) zur Wandlung des Signals q(t) in eine entsprechende Veränderung der optischen Übertragungseigenschaften der optischen Faserschleife (72).

19. Vorrichtung nach Anspruch 18, dadurch gekennzeichnet, daß der Wandler einen Phasenmodulator (70) umfaßt, der an einer Stelle der Schleife (72) gelegen ist, die von dem Mittelpunkt des optischen Pfades, der von der Schleife (72) geformt ist, versetzt ist, so daß die detektierte Phasendifferenz zwischen den gegenläufigen Lichtwellen sich in Abhängigkeit von der Größe Q ändert.

20. Vorrichtung nach einem der Ansprüche 18 oder 19, dadurch gekennzeichnet, daß ein Polarisator (36) vorgesehen ist, um zu bewirken, daß die Lichtquelle Licht einer ausgewählten Polarisation in die Schleife (72) einkoppelt.

21. Vorrichtung nach einem der Ansprüche 18 bis 20, dadurch gekennzeichnet, daß das Signal q(t) die Größe Q ist, die auf ein Vorspannungssignal aufmoduliert ist.

22. Vorrichtung nach einem der Ansprüche 18 bis 21, dadurch gekennzeichnet, daß das Signal q(t) in der Amplitude variiert.

23. Vorrichtung nach einem der Ansprüche 18 bis 22, dadurch gekennzeichnet, daß der Wandler (70) eine Phasenmodulation bewirkt, und zwar durch Strecken der optischen Faser derart, daß jede der ersten und zweiten Lichtwellen einen anderen, verschiedenen optischen Pfad um die Schleife (72) herumwandert, als sie bei Abwesenheit des Signals q(t) durchwandern würde.

24. Vorrichtung nach einem der Ansprüche 18, 29, 20, 22 oder 23, dadurch gekennzeichnet, daß Q schnell zietvariabel ist und daß q(t) direkt proportional zu Q ist.

25. Vorrichtung nach einem der Ansprüche 18 bis 24, dadurch gekennzeichnet, daß der Wandler (70) die Doppelbrechung der Faser in Abhängigkeit von q(t) ändert.

26. Vorrichtung nach einem der Ansprüche 18 bis 24, dadurch gekennzeichnet, daß der Wandler (70) die Fortpflanzungsgeschwindigkeit der ersten und zweiten Lichtwellen in Abhängigkeit von q(t) ändert.

27. Vorrichtung nach einem der Ansprüche 18 bis 26, dadurch gekennzeichnet, daß der Wandler (70) die relative Phasenlage der ersten und zweiten Lichtsignale in Abhängigkeit von q(t) verschiebt.

28. Vorrichtung nach Anspruch 20, dadurch gekennzeichnet, daß der Wandler (70) die Doppelbrechung der Faser in Abhängigkeit von q(t) verändert, wodurch bewirkt wird, daß ein Teil der Lichtwelle in den Polarisationsmodus gekoppelt wird, der senkrecht zu dem gewählten Polarisationsmodus liegt.

29. Vorrichtung nach Anspruch 28, dadurch gekennzeichnet, daß der Detektor (40) unabhängig Licht des gewählten Polarisationsmodus und des senkrechten Polarisationsmodus detektiert.

30. Verfahren zur Abfühlung einer zeitveränderlichen Größe, welche reziproke Effekte auf einer Differentialskala in einer optischen Faser erzeugt, umfassend die folgenden Schritte:

Verwendung eines optischen Faserinterferometers mit einer Schleife (24, 46, 72) einer optischen Faser, welche einen optischen Pfad bildet, der eine optische Pfadlänge besitzt, eine Lichtquelle (32) zur Erzeugung von Licht, eine Kopplungsvorrichtung (38) zur Aufteilung des Lichts in erste und zweite gegenläufige Lichtwellen, welche den optischen Pfad in entgegengesetzten Richtungen durchlaufen, und einen Detektor (40) zur Detektierung der Phasendifferenz zwischen den Lichtwellen nach dem Durchlaufen der optischen Pfadlänge, wobei das Verfahren durch die folgenden Schritte gekennzeichnet ist:

Aussetzen der gegenläufigen Lichtwellen der abzufühlenden Größe;

Anbringen der Größe an einem Punkt oder an Punkten, die von dem Mittelpunkt des Pfades um die Schleife herum versetzt sind, so daß die Teile der gegenläufigen Lichtwellen, die gleichzeitig an dem Detektor (40) eintreffen, durch unterschiedliche Werte der Größe beeinflußt worden sind, wodurch das Interferometer auf einer Globalskala nichtreziprok mit Bezug auf die abgefühlte Größe gemacht wird, um eine Phasenverschiebung zwischen den gegenläufigen Wellen zu verursachen, welche die abzufühlende Größe anzeigt; und

Detektieren der Phasenverschiebung zwischen den gegenläufigen Wellen.

31. Verfahren zum Abfühlen nach Anspruch 30, bei dem die zu fühlende Größe eine akustische Welle (26, 47) ist, welche Wellenfronten (28) vom Kompressionstyp und Wellenfronten (30) vom Verarmungstyp aufweist, ferner gekennzeichnet durch die folgenden Schritte:

Aussetzen eines Teils der ersten gegenläufigen Lichtwelle im wesentlichen ausschließlich entweder den Wellenfronten (28) vom Kompressionstyp oder den Wellenfronten vom Verarmungstyp der akustischen Welle (26, 47); und

Aussetzen des Teils der zweiten gegenläufigen Lichtwelle, welcher dem Teil der ersten gegenläufigen Lichtwelle entspricht, sowohl den Wellenfronten vom Kompressionstyp (28) und vom Verarmungstyp (30) der akustischen Welle (26, 47).

32. Verfahren zum Abfühlen einer akustischen Welle (26, 47) nach Anspruch 31, dadurch gekennzeichnet, daß die akustische Welle (26, 47) einen Verstärkungseffekt auf den Teil der gegenläufigen Lichtwelle ausübt, wobei die akustische Welle (26, 47) einen Versetzungseffekt auf den entsprechenden Teil der zweiten gegenläufigen Lichtwelle bildet.

33. Verfahren zum Abfühlen nach Anspruch 31 oder 32, zusätzlich gekennzeichnet durch:

Führen der gegenläufigen Lichtwellen durch wenigstens eine Spule (24) in der Schleife der optischen Faser, wobei die Spule eine Vielzahl von Windungen besitzt;

Positionieren der Spule (24) derart, daß die von den Windungen gebildeten Ebenen im wesentlichen senkrecht zur Fortpflanzungsrichtung (X) der akustischen Welle (26) liegen; und

Anordnen der Windungen im Abstand derart, daß die Entfernung zwischen zwei der Windungen eine Anpassung bewirkt von (a) der Fortpflanzungszeit einer der gegenläufigen Lichtwellen entlang der Fortpflanzungsrichtung der akustischen Welle (X) zwischen den zwei Windungen mit (b) der Fortpflanzungszeit der akustischen Welle (26) entlang der Fortpflanzungsrichtung (X) der akustischen Welle (26) zwischen den beiden Windungen.

34. Verfahren zum Abfühlen nach Anspruch 33, dadurch gekennzeichnet, daß die beiden Windungen benachbart sind.

35. Verfahren zum Abfühlen nach entweder Anspruch 31 oder 32, gekennzeichnet durch:

Führen der gegenläufigen Lichtwellen durch die optisch miteinander verbundenen Spulen (C1, C2) in der Schleife der optischen Faser; und

räumliches Trennen der beiden Spulen entlang der Fortpflanzungsrichtung (X) der akustischen Welle (47) um eine Strecke (d), die im wesentlichen gleich einem Viertel der Wellenlänge der akustischen Welle (47) ist.

36. Verfahren zum Abfühlen nach Anspruch 35, zusätzlich gekennzeichnet durch Bemessen des Umfangs jeder Spule (C1, C2) und Auswählen der Anzahl der Windungen der optischen Faser in jeder Spule derart, daß die Fortpflanzungszeit der gegenläufigen Lichtwellen durch jede Spule im wesentlichen gleich einem Viertel der Periode der akustischen Welle beträgt.

37. Verfahren zum Abfühlen einer akustischen Welle (26, 47) nach Anspruch 32, dadurch gekennzeichnet, daß der Verstärkungseffekt dadurch erzeugt wird, daß der Teil der ersten gegenläufigen Lichtwelle im wesentlichen dem gleichen Viertel eines Zyklus der akustischen Welle (26, 47) mehr als einmal ausgesetzt wird.

38. Verfahren zum Abfühlen einer Größe nach Anspruch 30, ferner gekennzeichnet durch die folgenden Schritte:

Erzeugen eines Signals q(t) in Abhängigkeit von der abzufühlenden Größe; und

Umwandeln des Signals q(t) in eine entsprechende Veränderung der optischen Eigenschaften der Schleife (72) an einer Stelle der Schleife, die von dem Mittelpunkt der optischen Pfadlänge versetzt ist, und zwar derart, daß die Phasendifferenz sich in Abhängigkeit von der Größe Q verändert.

**Revendications**

1. Appareil comprenant un intérféromètre optique à boucle fermée pour détecter une quantité dépendant du temps qui produit des effets réciproques sur une échelle différentielle dans une fibre optique, caractérisé par:

une boucle fermée (24, 46, 72) de fibre optique pour propager une première et une seconde ondes de lumière dans des directions opposées dans ladite boucle, ladite boucle (24, 46, 72) étant arrangée de telle sorte que, en état d'utilisation, la quantité qui doit être détectée est appliquée en un point ou en des points qui sont décalés par rapport au milieu du chemin optique dans la boucle de telle sorte que les parties des ondes de lumière se propageant dans des directions opposées et arrivant simultanément au détecteur (40) ont été influencées par des valeurs différentes de ladite quantité, rendant ainsi la boucle (24, 46, 72) non-réciproque sur une échelle globale par rapport à la quantité détectée, ce qui cause une différence de phase entre lesdites ondes de lumière se propageant dans des directions opposées;

une source de lumière (32) produisant lesdites ondes de lumière;

un coupleur (38) partageant un signal de lumière émanant de ladite source (32) en lesdites première et seconde ondes de lumière et couplant de manière optique lesdites première et seconde ondes de lumière dans ladite boucle (24, 46, 72) de telle sorte que lesdites première et seconde ondes de lumière se propagent dans des directions opposées dans ladite boucle (24, 42, 72); et

un détecteur (40) détectant la différence de phase entre lesdites première et seconde ondes de lumière se propageant dans des directions opposées.

2. Appareil tel qu'il est défini dans la revendication 1, caractérisé en ce que ledit détecteur (40) détecte ladite différence de phase en détectant l'intensité d'un signal combiné résultant de l'interférence desdites première et seconde ondes de lumière se propageant dans des directions opposées.

3. Appareil tel qu'il est défini dans la revendication 1 ou 2, caractérisé en ce que ladite source (32) produit de la lumière dans un état de polarisation sélectionné.

4. Appareil tel qu'il est défini dans l'une quelconque des revendications 1 à 3, caractérisé en ce que ladite source (32) et lesdits détecteurs (40) sont couplés à un polariseur (36) qui empêche, en grande partie, toute la lumière d'un état autre qu'un état de polarisation sélectionné de passer dans l'une ou l'autre direction.

5. Appareil tel qu'il est défini dans l'une quelconque des revendications 1 à 4, caractérisé en ce que ladite boucle (24, 46, 72) comprend un contrôleur de polarisation (44) qui contrôle la polarisation desdites première et seconde ondes de lumière se propageant dans des directions opposées.

6. Appareil tel qu'il est défini dans l'une quelconque des revendications 1 à 5, caractérisé en ce que ladite boucle (24, 46, 72) a une pluralité de boucles qui forment une bobine.

7. Appareil tel qu'il est défini dans la revendication 6, détectant une onde acoustique (26, 47) qui a des fronts d'onde du type compression (28) et des front d'onde du type raréfaction (30), ledit appareil étant caractérisé en ce que ladite bobine (24, 46) a une configuration telle que l'une des ondes de lumière se propageant dans des directions opposées est, en grande partie, exposée exclusivement à l'un ou l'autre des fronts d'onde du type compression ou raréfaction de ladite onde acoustique (26, 47) pendant la propagation de ladite onde de lumière à travers ladite bobine (24, 46), et l'autre desdites ondes de lumière se propageant dans des directions opposées est exposée à la fois aux fronts d'onde du type compression (28) et raréfaction (30) de ladite onde acoustique (26, 47) pendant la propagation de ladite onde de lumière à travers ladite bobine (24, 46).

8. Appareil tel qu'il est défini dans la revendication 7, caractérisé en ce que ladite bobine (24) est formée d'une fibre optique ayant une pluralité de boucles, le diamètre desdites boucles et l'écartement entre ces boucles étant sélectionné de manière que la composante de l'onde acoustique (26) qui se propage le long de l'axe longitudinal (X) de la bobine (24) se propage à peu près au même taux axial de propagation que ladite première onde de lumière qui se propage le long de l'axe (X) pendant la propagation à travers ladite bobine (24).

9. Appareil tel qu'il est défini dans la revendication 8, caractérisé en ce que ledit écartement est entre des boucles adjacentes de ladite bobine (24).

10. Appareil tel qu'il est défini dans l'une quelconque des revendications 7 à 9, caractérisé en ce que lesdites boucles sont à peu près perpendiculaires à la direction de propagation (X) de l'onde acoustique (26, 47).

11. Appareil tel qu'il est défini dans la revendication 7, caractérisé en ce que ladite bobine (46) comprend une première et une seconde bobine interconnectées de manière optique et faites de fibre optique (C1, C2).

12. Appareil tel qu'il est défini dans la revendication 11, caractérisé en ce que ladite première bobine (C1) est spatialement séparée de ladite seconde bobine (C2), de telle sorte que ladite première onde de lumière se propage d'abord à travers ladite première bobine (C1) et ensuite à travers la seconde bobine (C2), la séparation spatiale (d) entre les deux bobines (C1, C2) et le diamètre et le nombre de boucles dans chaque bobine (C1, C2) étant sélectionnés de façon à ce que la première onde de lumière est exposée, en grande partie, à la même portion de l'onde acoustique (47) pendant la propagation à travers ladite seconde bobine (C2) que pendant la propagation à travers la première bobine (C1).

13. Appareil tel qu'il est défini dans la revendication 12, caractérisé en ce que chacune desdites bobines (C1, C2) comprend un nombre de boucles de ladite fibre optique disposées autour d'un axe longitudinal (X), lesdites boucles étant séparées le long dudit axe (X) de telle sorte que les ondes de lumière se propageant dans des directions opposées dans lesdites boucles (C1, C2) se propagent dans des plans, en grande partie, parallèlles aux plans (60) de l'onde acoustique (47), et le temps de transit optique entre les portions correspondantes des bobines (C1, C2) est approximativement un quart de la période de ladite onde acoustique (47).

14. Appareil tel qu'il est défini dans la revendication 12, caractérisé en ce que chacune desdites bobines (C1, C2) a une configuration telle que le temps de transit à travers ces bobines pour ladite onde de lumière est, en grande partie, égal à une fraction prédéterminée de la période de l'onde acoustique (47) et dans lequel les bobines (C1, C2) sont séparées par une distance (d) qui est approximativement égale une fraction de la longueur d'onde de l'onde acoustique (47) qui correspond à la fraction du temps de transit dans chaque bobine (C1, C2) par rapport à la période de l'onde acoustique (47).

15. Appareil tel qu'il est défini dans la revendication 13 ou 14, caractérisé en ce qu'une portion de fibre optique de transfert (62) est disposée entre lesdites bobines (C1, C2) de telle sorte que le temps de transit optique de ladite portion de fibre optique de transfert est, en grande partie, supérieur au temps de transit de ladite onde acoustique (47) entre lesdites bobines (C1, C2).

16. Appareil tel qu'il est défini dans la revendication 14, caractérisé en ce que la séparation spatiale (d) entre lesdites bobines (C1, C2) est égale approximativement à un quart de la longueur d'onde de l'onde acoustique (47).

17. Appareil tel qu'il est défini dans la revendication 14, caractérisé en ce que chacune desdites bobines (C1, C2) a une telle configuration que le temps de transit des longeurs desdites ondes de lumière se propageant dans des directions opposées à travers chacune desdites boucles (C1, C2) est approximativement égal au temps requis par l'onde acoustique (47) pour se propager une distance égale à un quart de la longeur d'onde de ladite onde acoustique (47).

18. Appareil tel qu'il est défini par l'une quelconque des revendications 1 à 5, caractérisé de plus par:

un modulateur (68) pour détecter une quantité Q, et transformer la quantité Q en un signal q(t) dépendant du temps; et

un transducteur (70) pour convertir le signal q(t) en un changement correspondant des propriétés de transmission optiques de ladite boucle de fibre optique (72).

19. Appareil tel qu'il est défini dans la revendication 18, caractérisé en ce que ledit transducteur comprend un modulateur de phase (70) positioné à un endoit sur ladite boucle (72) qui est décalé par rapport au centre du chemin optique formé par ladite boucle (72) de telle sorte que la différence de phase détectée entre les ondes de lumière se prpoageant dans des différentes directions varie en fonction de la quantité Q.

20. Appareil tel qu'il est défini dans l'une quelconque des revendications 18 ou 19, caractérisé de plus par un polariseur (36) qui agit de telle sorte que la source de lumière couple la lumière d'un état de polarisation présélectionné dans ladite boucle (72).

21. Appareil tel qu'il est défini dans l'une quelconque des revendications 18 à 20, caractérisé en ce que le signal q(t) est la quantité Q modulée par un signal de modulation.

22. Appareil tel qu'il est défini dans l'une quelconque des revendications 18 à 21, caractérisé en ce que ledit signal q(t) varie en amplitude.

23. Appareil tel qu'il est défini dans l'une quelconque des revendications 18 à 22, caractérisé en ce que ledit transducteur (70) crée une démodulation de phase en étirant la fibre optique de telle sorte que chacune desdites première et seconde ondes de lumière se propage le long d'un chemin optique dans la boucle (72) différent du chemin optique le long duquel elle se propagerait en l'absence dudit signal q(t).

24. Appareil tel qu'il est défini dans l'une quelconque des revendications 18, 19, 20, 22 ou 23, caractérisé en ce que la quantité Q varie rapidement avec le temps et q(t) est directement proportionnel à la quantité Q.

25. Appareil tel qu'il est défini dans l'une quelconque des revendications 18 à 24, caractérisé en ce que ledit transducteur (70) change la biréfringence de ladite fibre en réponse à q(t).

26. Appareil tel qu'il est défini dans l'une quelconque des revendications 18 à 24, caractérisé en ce que ledit transducteur (70) change la vélocité de propagation desdites première et seconde ondes de lumière en réponse à q(t).

27. Appareil tel qu'il est défini dans l'une quelconque des revendications 18 à 26, caractérisé en ce que le transducteur (70) fait varier la phase relative desdits premier et second signaux de lumière en réponse à q(t).

28. Appareil tel qu'il est défini dans la revendication 20, caractérisé en ce que ledit transducteur (70) change la biréfringence de ladite fibre en réponse à q(t), ainsi couplant dans ledit mode de polarisation sélectionné une portion de ladite onde de lumière qui se trouve dans le mode de polarisation orthogonal.

29. Appareil tel qui est défini dans la revendication 28, de plus caractérisé en ce que le détecteur (40) détecte la lumière dudit mode de polarisation orthogonal de manière indépendante.

30. Méthode pour détecter une quantité qui varie avec le temps et qui produit des éffets réciproques sur une échelle différentielle dans une fibre optique, comprenant l'étape suivante:

l'utilisation d'un interféromètre à fibre optique comprenant une boucle (24, 46, 72) de fibre optique formant un chemin optique ayant une longeur de chemin optique, une source de lumière (32) qui produit de la lumière, un dispositif de couplage (38) pour partager la lumière en une première et une seconde onde de lumière, ces ondes se propageant dans des directions opposées et traversant ledit chemin optique dans des directions opposées, et un détecteur (40) pour détecter la différence de phase entre les ondes de lumière après avoir parcouru la longeur de chemin optique, ladite méthode étant caractérisée par les étapes suivantes:

l'exposition desdites ondes de lumière se propageant dans des directions opposées à une quantité qui doit être détectée;

l'application de ladite quantité en un point ou en des points qui sont décalés par rapport au milieu de chemin autour de la boucle de telle sorte que les parties des ondes de lumière se propageant dans des directions opposées et arrivant simultanément au détecteur (40) ont étaient influencées par des valeurs différentes de ladite quantité, rendant ainsi l'interféromètre nonréciproque sur une échelle globale par rapport à la quantité à détecter, de telle sorte que cela produit une différence de phases entre les ondes de lumière se propageant dans des directions opposées qui est indicative de la quantité à détecter; et

la détection de la différence de phase entre lesdites ondes de lumière se propageant des directions opposées.

31. Méthode de détection telle qu'elle a été définie dans la revendication 30, dans laquelle ladite quantité à détecter comprend une onde acoustique (26, 47) qui a des fronts d'onde de type compression (28) et des fronts d'onde de type raréfaction (30), de plus caractérisée par les étapes suivantes:

l'exposition d'une portion de ladite première onde de lumière, en grande partie, exclusivement aux fronts d'onde du type compression ou aux fronts d'onde du type raréfaction (28) de ladite onde acoustique (26, 47); et

l'exposition de la portion de ladite seconde onde de lumière qui correspond à ladite portion de ladite première onde de lumière à la fois à des fronts d'onde de type compression (28) et à des fronts d'onde du type raréfaction (30) de ladite onde acoustique (26, 47).

32. Méthode de détection telle qu'elle a été définie dans la revendication 31, caractérisée en ce que ladite onde acoustique (26, 47) fournit un effet de renforcement sur ladite portion de ladite première onde de lumière, et dans laquelle ladite onde acoustique (26, 47) fournit un effet de décalage sur ladite portion correspondante de ladite seconde onde de lumière.

33. Méthode de détection telle qu'elle a été définie dans la revendication 31 ou 32, caractérisée de plus par les étapes de:

guidage des ondes de lumière se propageant dans des directions opposées à travers au moins une bobine (24) dans ladite boucle de fibre optique, ladite bobine ayant une pluralité de boucles;

positionnement de ladite bobine (24) de telle sorte que les plans formés par lesdites boucles sont, en grande partie, perpendiculaires à la direction de propagation (X) de ladite onde acoustique (26); et

écartement des boucles de telle sorte que la distance entre deux desdites boucles fait correspondre (a) le temps de propagation de l'une des ondes de lumière se propageant dans des directions opposées le long de la direction de propagation de l'onde acoustique (X) entre lesdites deux boucles avec (b) le temps de propagation de l'onde acoustique (26) le long de la direction de propagation (X) de l'onde acoustique (26) entre lesdites deux boucles.

34. Méthode de détection telle qu'elle a été définie dans la revendication 33, caractérisée en ce que lesdites deux boucles sont adjacentes.

35. Méthode de détection telle qu'elle a été définie dans la revendication 31 ou 32, caractérisée par le:

guidage des ondes de lumière se propageant dans des directions opposées à travers lesdites bobines (C1, C2) interconnectées optiquement dans ladite boucle de fibre optique; et

l'écartement spatial des deux bobines le long de la direction de propagation (X) de l'onde acoustique (47) d'une distance (d), en grande partie, égale à un quart de la longueur d'onde de l'onde acoustique (47).

36. Méthode de détection telle qu'elle a été définie dans la revendication 35, caractérisée de plus par le choix de la circonférence de chaque bobine (C1, C2) et le choix du nombre du boucles de fibre optique dans chaque bobine de telle sorte que le temps de propagation des ondes de lumière se propageant dans des directions opposées à travers chaque bobine est, en grande partie, égal à un quart de la période de l'onde acoustique.

37. Méthode de détection telle qu'elle a été définie dans la revendication 32, caractérisée en ce que ledit effet de renforcement est créé par l'exposition de ladite portion de ladite première onde de lumière en grande partie au même quart de cycle de l'onde acoustique (26, 47) plus d'une fois.

38. Méthode de détection telle qu'elle a été définie dans la revendication 30, caractérisée de plus par les étapes de:

génération d'un signal q(t) en réponse à la quantité qui doit être détectée; et

la conversion du signal q(t) en un changement correspondant des propriétés optiques de la boucle (72) en un endroit sur ladite boucle qui est décalé par rapport au milieu de la longueur de chemin optique de telle sorte que ladite différence de phase varie en fonction de la quantité Q.

FIG.-1

LIGHT SOURCE 10

12

DIRECTIONAL COUPLER 18

POLARIZER 13

DIRECTIONAL COUPLER 14

16

N-TURN FIBER COIL

DETECTOR 20

FIG.-2

ACOUSTIC WAVE

26

L 24

A

B

30

32

28

SOURCE 34

DIRECTIONAL COUPLER 42

36 P

B 44

38

DETECTOR 40

DIRECTIONAL COUPLER

FIG.-3

47

PC 44

L1 46 L2

C1

C2

62

38

36 P

42 32

S

d

D 40

60

FIG.- 4

FIG.- 5